# FASCICULE DE BREVET EUROPEEN

(11) **EP 2 652 166 B1**
(45) Date de publication et mention de la délivrance du brevet: **11.02.2015**
(21) Numéro de dépôt: 10810765.7
(22) Date de dépôt: 17.12.2010
(51) Int. Cl.: C23C 14/16, C23C 14/58, C23C 28/00, C23C 28/02, C23C 2/06, C23C 2/26, C23C 2/40

(54) **TÔLE D'ACIER COMPRENANT UN REVÊTEMENT MULTICOUCHE**
STAHLBLECH MIT MEHRSCHICHTIGEM ÜBERZUG
STEEL SHEET INCLUDING A MULTILAYER COATING

(43) Date de publication de la demande: 23.10.2013
(73) Titulaire: Arcelormittal Investigación y Desarrollo SL, 48910 Sestao, Bizkaia (ES)
(72) Inventeur: MONNOYER, Maxime, F-57255 Sainte-Marie-aux-Chenes (FR); CHALEIX, Daniel, F-57420 Verny (FR); ALLELY, Christian, F-57000 Metz (FR); JACQUES, Daniel, F-57100 Thionville (FR); CHASSAGNE, Julie, B-4000 Liege (BE)
(74) Mandataire: Domenego, Bertrand
(86) Numéro de dépôt international: PCT/FR2010/000848
(87) Numéro de publication internationale: WO 2012/080581

(56) Documents cités:
- EP-A1- 0 636 709
- EP-A1- 0 890 655
- EP-A2- 2 213 757
- FR-A- 1 572 638
- GB-A- 2 161 499
- LU-A1- 86 738

## Description

La présente invention est relative à une tôle d'acier comprenant un revêtement multicouche dont au moins une couche comprend un alliage zinc-magnésium, qui est plus particulièrement destinée à la fabrication de pièces pour l'automobile, sans pour autant y être limitée.

Les revêtements galvanisés comprenant essentiellement du zinc sont traditionnellement utilisés pour leur bonne protection contre la corrosion, que ce soit dans le secteur automobile ou dans la construction, par exemple. Cependant, ces revêtements génèrent des problèmes de soudabilité et sont à présent concurrencés par les revêtements de zinc comprenant du magnésium.

En effet, l'ajout de magnésium augmente nettement la résistance à la corrosion perforante de ces revêtements, ce qui peut permettre de réduire leur épaisseur et donc d'améliorer leur aptitude au soudage ou bien encore de maintenir l'épaisseur de revêtement et d'augmenter la garantie de protection contre la corrosion dans le temps.

En outre, l'amélioration de la résistance à la corrosion est telle qu'il est à présent possible de réduire voire de supprimer l'utilisation de mesures de protection secondaires telles que l'utilisation de cires ou de mastics aux endroits les plus susceptibles d'être corrodés.

Cependant, les bobines d'acier portant de tels revêtements en surface peuvent parfois séjourner dans des hangars de stockage pendant plusieurs mois et ne doivent pas voir cette surface s'altérer par l'apparition d'une corrosion de surface, avant d'être mises en forme par l'utilisateur final. En particulier, aucune amorce de corrosion ne doit apparaître quel que soit l'environnement de stockage, même en cas d'exposition au soleil et/ou à un environnement humide voire salin.

Les produits galvanisés standard sont eux aussi soumis à ces contraintes et sont enduits d'une huile de protection qui est généralement suffisante.

Or, les présents inventeurs ont constaté que les revêtements comprenant du magnésium ne permettent pas d'obtenir une protection temporaire contre la corrosion suffisante, même après avoir été enduits d'huile de protection. On observe en effet la formation de points noirs correspondants à la formation d'un oxyde de zinc-magnésium.

Il existe donc un besoin pour développer un système de protection temporaire efficace pour de tels revêtements.

En outre, un tel système doit être compatible avec les étapes ultérieures de fabrication comme la mise en peinture (aptitude à la phosphatation) et être éliminable facilement, d'où sa qualification de temporaire.

Pour le domaine de l'automobile, il doit en outre assurer une bonne protection contre la corrosion cosmétique qui désigne la dégradation d'aspect des pièces visibles d'un véhicule ayant subi un gravillonnage, des chocs, des rayures, ainsi que des tranches et coins des panneaux constituant le véhicule.

Par ailleurs, la réalisation de tels systèmes de protection temporaire doit se faire dans des conditions industrielles, c'est à dire qu'elle doit de préférence permettre d'obtenir des dépôts d'une épaisseur pouvant atteindre 100 nm par face à des vitesses de défilement pouvant atteindre 300 m/min.

Le but de la présente invention est de remédier aux inconvénients des aciers revêtus et procédés de fabrication de l'art antérieur en mettant à disposition une tôle d'acier revêtu présentant à la fois une bonne résistance contre la corrosion perforante et une bonne résistance contre la corrosion de surface, à l'aide d'un système de protection temporaire qui soit éliminable facilement avant la mise en peinture. Elle doit également présenter, de préférence, une bonne résistance contre la corrosion cosmétique et une bonne aptitude à la phosphatation. Le procédé de fabrication doit, quant à lui, permettre d'atteindre des vitesses de traitement compatibles avec les exigences industrielles.

A cet effet, l'invention a pour premier objet une tôle d'acier munie d'un revêtement multicouche comprenant au moins une couche à base de zinc comprenant de 0,1 à 20% en poids de magnésium, surmontée d'une couche de protection temporaire de fine épaisseur comprise entre 5 et 100 nm et constituée de métal ou d'oxyde métallique choisi dans le groupe constitué de l'aluminium, du chrome, des oxydes d'aluminium AlOx, x étant strictement compris entre 0,01 et 1,5 et des oxydes de chrome CrOy, y étant strictement compris entre 0,01 et 1,5, ladite couche à base de zinc et comprenant 0,1 à 20% en poids de magnésium n'étant pas alliée avec ladite couche de protection temporaire..

La tôle selon l'invention peut également comprendre les caractéristiques suivantes, prises isolément ou en combinaison :
- le revêtement multicouche comprend une première couche à base de zinc comprenant moins de 0,05% en poids de magnésium, surmontée d'une seconde couche à base de zinc comprenant de 0,1 à 20% en poids de magnésium, elle-même surmontée d'une couche de protection temporaire de fine épaisseur comprise entre 5 et 100 nm et constituée de métal ou d'oxyde métallique choisi dans le groupe constitué de l'aluminium, du chrome, des oxydes d'aluminium AlOx, x étant strictement compris entre 0,01 et 1,5 et des oxydes de chrome CrOy, y étant strictement compris entre 0,01 et 1,5, ladite couche à base de zinc et comprenant 0,1 à 20% en poids de magnésium n'étant alliée ni avec ladite couche de protection temporaire ni avec ladite couche à base de zinc et comprenant moins de 0,05% en poids de magnésium ;
- la ou les couches à base de zinc comprennent en outre de 0,1 à 10% en poids d'aluminium,
- la couche à base de zinc comprenant de 0,1 à 20% en poids de magnésium est constituée de Zn₂Mg,
- la couche de protection temporaire est constituée d'aluminium,
- la couche de protection temporaire présente une épaisseur comprise entre 5 et 50 nm.

L'invention a également pour deuxième objet un procédé de fabrication d'une tôle comprenant un revêtement multicouche selon l'invention, selon lequel on alimente une tôle d'acier nue, puis on la revêt successivement des différentes couches constituant ledit revêtement multicouche, la couche de protection temporaire étant déposée par dépôt sous vide.

Dans un mode de réalisation préféré, toutes les couches du revêtement multicouche sont déposées par dépôt sous vide.

L'invention a également pour troisième objet un procédé de fabrication d'une à partir d'une tôle selon l'invention, selon lequel on enduit ladite tôle d'une huile lubrifiante en une quantité inférieure ou égale à 1 g/m², puis on met en forme ladite tôle par emboutissage, puis on la soumet à un dégraissage alcalin.

D'autres caractéristiques et avantages de l'invention apparaîtront à la lecture de la description qui va suivre, donnée uniquement à titre d'exemple non limitatif.

La tôle revêtue selon l'invention comprend tout d'abord un substrat en acier, de préférence laminé à chaud puis laminé à froid pour pouvoir être utilisé en tant que pièce de carrosserie pour l'automobile. L'invention n'est pas pour autant limitée à ce domaine et peut trouver un emploi pour toute pièce en acier quel que soit son usage final.

Cette tôle est munie d'un revêtement multicouche comprenant nécessairement une couche à base de zinc comprenant de 0,1 à 20% en poids de magnésium, que l'on désignera dans la suite comme étant une couche à base de zinc comprenant du magnésium. Cette couche de revêtement présente généralement une épaisseur inférieure ou égale à 20 µm et vise à protéger le substrat en acier contre la corrosion perforante, de façon classique. On ajoute au moins 0,1% en poids de magnésium car aucun effet de protection contre la corrosion perforante n'est visible en deçà. Dans un mode de réalisation préféré, on ajoute au moins 0,5%, de préférence au moins 2% en poids de magnésium. On limite sa teneur à 20% en poids car il a été observé qu'une proportion plus importante entrainerait une consommation trop rapide du revêtement et donc des performances anticorrosion paradoxalement dégradées.

Cette couche de revêtement pourra notamment être obtenue par un procédé de dépôt sous vide, tel que le sputtering magnétron, le dépôt par faisceau d'électrons ou l'évaporation sous vide par effet joule ou par induction. Dans ce cas, la couche ne comprendra généralement que du zinc et du magnésium, d'autres éléments, tels que l'aluminium ou le silicium pouvant cependant être ajoutés, si nécessaire, pour améliorer d'autres caractéristiques du revêtement telles que sa ductilité ou son adhésion au substrat. Lorsque le revêtement ne comprend que du zinc et du magnésium, on préfère en particulier que la couche de revêtement comprenne entre 14 et 18% en poids de magnésium, et mieux qu'elle corresponde majoritairement au composé intermétallique de formule Zn₂Mg, comportant environ 16% en poids de magnésium, qui présente des propriétés de résistance à la corrosion perforante particulièrement bonnes.

Lorsque le revêtement comprend du zinc, du magnésium et de l'aluminium, on préfère en particulier que la couche de revêtement comprenne entre 2 et 4% en poids de magnésium et entre 2 et 4% en poids d'aluminium, c'est à dire qu'elle soit proche de la composition de l'eutectique ternaire zinc/aluminium/magnésium.

Lorsqu'elle est appliquée directement sur l'acier, cette couche de revêtement pourra également être obtenue par un procédé de revêtement au trempé à chaud dans un bain de zinc fondu contenant du magnésium et de l'aluminium jusqu'à une teneur de 10 % en poids. Le bain peut également contenir jusqu'à 0,3% en poids d'éléments optionnels d'addition tels que Si, Sb, Pb, Ti, Ca, Mn, Sn, La, Ce, Cr, Ni, Zr ou Bi. Ces différents éléments peuvent permettre, entre autres, d'améliorer la ductilité ou l'adhésion du revêtement, par exemple. L'homme du métier qui connaît leurs effets sur les caractéristiques du revêtement saura les employer en fonction du but complémentaire recherché. Le bain peut enfin contenir des éléments résiduels provenant des lingots d'alimentation ou résultant du passage de la bande dans le bain.

Le revêtement multicouche de la tôle selon l'invention comprend ensuite nécessairement une couche de fine épaisseur comprise entre 5 et 100 nm, de préférence entre 5 et 90 nm, de façon plus particulièrement préférée entre 5 et 50 nm, voire entre 5 et 40 nm, d'un métal choisi parmi l'aluminium et le chrome ou d'un oxyde métallique d'aluminium ou de chrome de formules respectives AlOx et CrOy tels que x et y soient strictement compris entre 0,01 et 1,5. Cette couche qui est située juste au-dessus de la couche de revêtement à base de zinc comprenant du magnésium a pour fonction principale d'assurer sa protection temporaire. Son épaisseur minimale est fixée à 5 nm car la protection obtenue n'est pas suffisante en deçà. L'épaisseur maximale est fixée à 100 nm pour permettre d'éliminer facilement la plus grande partie, voire la totalité de cette couche par un simple dégraissage alcalin, en particulier lorsque les traitements ultérieurs de la tôle le rende nécessaire ou bien pour ne pas réduire l'aptitude de la tôle à être phosphatée et/ou peinte.

Cette couche est constituée d'aluminium, de chrome ou d'oxydes sous-stoechiométriques de ces éléments. Dans le cadre de la présente invention, on entend par oxydes sous stoechiométriques des oxydes d'aluminium AlOx et de chrome CrOy tels que x et y soient strictement compris entre 0,01 et 1,5. Cette définition exclut donc les oxydes dits stoechiométriques pour lesquels x vaut 1,5 et dont la formule est généralement représentée par Al₂O₃ et Cr₂O₃.

L'invention vise plus particulièrement le dépôt de ces oxydes sous-stoechiométriques car ils présentent de bonnes performances en protection temporaire.

Il est en outre possible de les déposer par dépôt sous vide avec une vitesse de dépôt compatible avec les exigences industrielles, c'est-à-dire de réaliser des dépôts allant jusqu'à 100 nm par face à des vitesses de défilement pouvant atteindre 300 m/min.

Comme on l'aura compris, cette couche peut être déposée par tout procédé de dépôt sous vide adapté, tel que le sputtering magnétron, le dépôt par faisceau d'électrons ou l'évaporation sous vide par effet joule ou par induction.

Le procédé de dépôt sous vide employé pour le dépôt de cette couche dépendra essentiellement de sa nature. Ainsi, pour le dépôt de l'aluminium ou du chrome sous forme métallique, on utilisera de préférence le sputtering magnétron. Ce dépôt est réalisé dans un plasma (généralement d'Argon), par bombardement ionique d'une cible métallique composée du métal à déposer.

Lorsque l'on souhaite déposer de l'oxyde d'aluminium ou de l'oxyde de chrome, ce procédé peut également être employé. Il suffit alors d'injecter un gaz réactif qui sera ici O₂. Les ions Ar⁺ du plasma bombardent la cible et en arrachent des atomes qui se déposent sur le substrat tout en réagissant avec l'oxygène pour donner le dépôt désiré.

Pour pouvoir conserver un bon rendement de dépôt de ces oxydes aux vitesses classiques des lignes de revêtement métallique en utilisant ce procédé, il est impératif de se limiter à des valeurs de x et de y strictement inférieures à 1,5 car on a observé qu'au delà de cette limite, les vitesses de dépôt chutent brutalement, étant divisées par 7 dès le franchissement de ce seuil.

En effet, on constate que l'oxygène réagit tout d'abord avec le plasma, les particules métalliques pulvérisées, les parois de la chambre, la cible, si bien que sa pression partielle augmente lentement. Dans le même temps, le rendement de pulvérisation et donc la vitesse de dépôt restent élevés.

Une fois que la surface de la cible ainsi que les parois de la cuve sont saturés en oxyde, on atteint alors le débit critique d'oxygène au delà duquel le gaz ne réagit plus que très peu avec le métal ce qui entraîne une augmentation brutale de sa pression partielle. Dans le même temps, le rendement de pulvérisation et donc la vitesse de dépôt chutent car la surface de la cible est oxydée.

Un autre procédé de dépôt plus particulièrement préféré est le dépôt par évaporation sous vide, avec chauffage du matériau à déposer contenu dans un creuset par tout procédé adapté tel que par canon à électrons, par induction ou par résistance, par exemple. Ce chauffage sous vide du creuset contenant le matériau à déposer sous forme solide ou liquide donne lieu à la formation d'une vapeur, qui en, se condensant sur le substrat porté à une température plus faible que celle de la vapeur, mène à la formation d'un dépôt.

A une pression et une température données, plus le taux d'évaporation du matériau est élevé, plus la vitesse de dépôt est élevée. Le taux d'évaporation du matériau à déposer est lié à sa pression de vapeur saturante. A une température donnée, l'évaporation aura lieu si la pression de vapeur saturante est supérieure à la pression totale régnant dans la chambre de dépôt.

Lorsqu'on souhaite déposer un oxyde sous stoechiométrique tel que défini précédemment, on pourra employer ce procédé en créant un plasma, par exemple un plasma à base d'Argon, au-dessus du creuset d'évaporation et en injectant de l'oxygène dans l'enceinte sous vide, réalisant ainsi une évaporation réactive.

Les techniques d'évaporation et d'évaporation réactive ne permettent cependant pas de déposer des oxydes stoechiométriques tels que Al₂O₃ et Cr₂O₃ en raison de leur pression de vapeur qui est très inférieure à celle des composés métalliques purs correspondants. Ainsi, l'évaporation d'oxydes tels que Al₂O₃ et Cr₂O₃ à des vitesses raisonnables n'est pas possible à des températures de l'ordre de celles que l'on pourrait utiliser pour l'Al ou le Cr. L'utilisation de ce procédé impose donc également de limiter les valeurs de x et y à des valeurs strictement inférieures à 1,5.

Il est à noter que d'autres éléments tels que le titane, le zirconium ou le zinc, sous forme métallique ou sous forme d'oxyde ne peuvent être utilisés car leur vitesse de dépôt est insuffisante, quel que soit le procédé de dépôt sous vide employé. Pour obtenir avec ces éléments des rendements équivalents à ceux de l'aluminium ou du chrome, il serait nécessaire d'élever fortement les températures de chauffage (au-delà de 2500°C), ce qui n'est pas souhaitable du point de vue de la sécurité, de la conception et de la maintenance des installations, ainsi que de leur durée de vie.

Dans un mode de réalisation préféré, la tôle d'acier comprend un autre revêtement à base de zinc situé sous le revêtement à base de zinc comprenant du magnésium. Cette couche de revêtement comprend moins de 0,05% en poids de magnésium et de préférence pas de magnésium. Elle peut cependant contenir jusqu'à 0,3% en poids d'éléments optionnels d'addition tels que Si, Sb, Pb, Ti, Ca, Mn, Sn, La, Ce, Cr, Ni, Zr ou Bi et jusqu'à 0,3% en poids d'aluminium.

Elle pourra être déposée sur la tôle d'acier par tout moyen connu de l'homme du métier, tel que le dépôt au trempé à chaud, par électro-zingage ou bien encore par dépôt sous vide, comme décrit précédemment pour la couche à base de zinc et de magnésium.

Lorsque cette couche est présente, son épaisseur est en général comprise entre 1 et 10 µm, de préférence entre 1 et 6 µm. L'épaisseur de la couche à base de zinc et de magnésium peut alors être réduite et sera de préférence comprise entre 1 et 4 µm.

Une des caractéristiques du revêtement selon l'invention est que la couche à base de zinc comprenant du magnésium n'est pas alliée avec la couche de protection temporaire, ni avec la couche sous-jacente à base de zinc, lorsque celle-ci est présente dans le revêtement multicouche. De préférence, cette couche à base de zinc comprenant du magnésium n'est pas obtenue par suite de l'alliation d'une couche à base de zinc et d'une couche à base de magnésium, mais directement par le dépôt d'un alliage de zinc et de magnésium.

Cette caractéristique permet de contrôler avec précision la composition de cette couche dont dépendent les propriétés de tenue en corrosion perforante, essentielles pour l'industrie. Elle permet en outre d'éviter de mettre en oeuvre un traitement thermique de diffusion qui ajouterait une étape supplémentaire au procédé de fabrication et est délicat à piloter, toute diffusion entre le substrat et le revêtement devant généralement être évitée.

On emploiera ainsi de préférence un procédé de fabrication dans lequel la totalité des couches de revêtement sont déposées par un procédé sous vide, ce qui aura en outre l'avantage de ne pas devoir opérer sous atmosphère inerte.

L'invention va à présent être explicitée par des essais réalisés à titre indicatif et non limitatif.

### Tests

### Corrosion de surface

Le test pratiqué est également appelé « test humidotherme » et se pratique dans une chambre climatique selon la norme DIN EN ISO 6270-2.

La protection temporaire contre la corrosion peut être évaluée sur des panneaux plans simulant une tôle lors du stockage ou du transport, ou sur des panneaux déformés représentant une pièce métallique (par exemple une porte de voiture) emboutie à un endroit et transportée à un autre.

Chaque panneau à tester est dégraissé puis enduit sur les deux faces avec une huile appropriée à l'aide d'un appareil d'huilage par aspersion selon la norme VDA 230-213, avec un poids de couche d'huile de 1,2 g/m². Les panneaux sont huilés à l'aide de Fuchs Anticorit RP 4107s à 1,2 g/m² lorsque le test est effectué pour un constructeur allemand ou à l'aide de Quaker Ferrocoat N 6130 lorsque le test est effectué pour un constructeur français. Ceux-ci sont laissés non assemblés et non peints.

Une série de cycles de vieillissement de 24 heures est ensuite appliquée aux panneaux, chaque cycle incluant :
- 8 heures à 50°C±3°C et environ 98% d'humidité relative (chambre climatique fermée, y compris durant la chauffe), puis
- 16 heures à 21°C±3°C et moins de 98% d'humidité relative (chambre climatique ouverte ou ventilée, y compris durant le refroidissement).

A la fin de la série de cycles, la modification de l'aspect de surface des panneaux est évaluée en terme de pourcentage de la surface ayant été altérée.

La proportion de modification de l'aspect de surface doit être inférieure à 15% après 10 cycles pour les échantillons traités avec l'huile Quaker ou après 15 cycles pour les échantillons traités avec l'huile Fuchs.

### Aptitude à la phosphatation

Les échantillons sont dégraissés et phosphatés dans les conditions suivantes :

| Etape | Produit(s) | Paramètres | Température | Durée |
|---|---|---|---|---|
| 1-Dégraissage alcalin | Gardoclean S5176 15 +/- 0,3 g/l | Alcalinité libre = 6,8-7,4 pts | 55°C +/- 1°C | 6 min |
| | Gardobond H7352 1,5 +/- 0,1g/l | | | |
| 2 - Rinçage | Eau dure | | ambiante | 1 min |
| 3 - Activation | Gardolene V6513 ("Powder refiner") 0,3 à 0,4 g/l | | ambiante | 45 s |
| 4-Phosphatation | Gardobond R24 TA, Gardobond H7141, H7164, H7257, H7101, H7155 | Acidité libre = 1-1,2 pts Fluorures libres = 230 +/- 50 ppm Taux compensateur = 1,5-2,5 pts | 50°C +/- 1°C | 3 min |
| 5 - Rinçage | Eau dure puis déminéralisée | | ambiante | 1 à 2 min |

On évalue ensuite le degré de recouvrement de la couche de phosphatation à l'aide d'un microscope électronique à balayage : l'apparition au microscope de zones brillantes sera un signe de l'absence de film de phosphate, alors que les zones mates correspondront aux surfaces correctement phosphatées. La valeur cible est fixée à 100% de recouvrement de la surface étudiée.

### Corrosion cosmétique

La corrosion cosmétique est évaluée sur des échantillons peints, non assemblés et ayant subis une rayure de 1 mm de large. La profondeur de la rayure est telle qu'elle traverse le revêtement et atteint l'acier.

Les échantillons sont soumis à dix cycles de tests de corrosion cyclique selon la norme VDA 621-415, chaque cycle d'une semaine incluant :
- 24 heures de brouillard salin (NaCl 5%, 1,5 ml/h) à 35°C
- Puis quatre fois l'enchainement :
   ∘ 8 heures à 40°C et environ 99% d'humidité relative, puis
   ∘ 16 heures à 23°C et environ 50% d'humidité relative
- Puis 48 heures à 23°C et environ 50% d'humidité relative.

La cotation de la délamination au niveau de la rayure est ensuite réalisée : on mesure la largeur maximale de dégradation des échantillons autour de la rayure, qui se manifeste sous la forme d'un cloquage de la peinture, puis on retranche la largeur de rayure et on divise par deux. La cotation se fait à l'aide de gabarits qui prennent la forme de rectangles de tailles différentes tracés sur un support transparent. Ils permettent de déterminer la largeur maximale de dégradation en les superposant avec la rayure à coter : on retient le rectangle encadrant au plus juste la surface dégradée.

### Essais

On réalise trois séries de trois échantillons de tôle d'acier laminée à froid de type DC06 tel que commercialisé par ArcelorMittal, comprenant un premier revêtement de zinc d'une épaisseur de 6 µm surmonté d'un revêtement d'alliage de zinc et de magnésium correspondant à la formule Zn₂Mg et d'une épaisseur de 3 µm. Ces deux couches de revêtement ont été déposées par un procédé d'évaporation sous vide par induction.

Une partie des échantillons reçoivent ensuite sur une installation de laboratoire une couche supplémentaire de revêtement défini selon les caractéristiques rassemblées dans le tableau 1. Ces revêtements sont obtenus par sputtering magnétron. Dans le cas de l'essai n°3, on a utilisé un procédé de sputtering magnétron réactif avec injection d'un débit de 500 cm³/min d'oxygène.

**Tableau 1**

| Echantillon | Revêtement |
|---|---|
| 1 | Pas de dépôt supplémentaire |
| 2* | 50 nm d'aluminium |
| 3* | 50 nm de CrOₓ avec x = 1,45 |

| | |
|---|---|
| * : selon l'invention | |

On les soumet ensuite aux tests de corrosion de surface, d'aptitude à la phosphatation et de corrosion cosmétique. Les résultats sont rassemblés dans le tableau 2 :

**Tableau 2**

| Echantillon | Corrosion de surface (%) | Phosphatation (% recouvrement) | Corrosion cosmétique (largeur max - mm) |
|---|---|---|---|
| 1 | 100 | 100 | 3 |
| 2* | <5 | 100 | 2 |
| 3* | <5 | 100 | 2 |

| | | | |
|---|---|---|---|
| * : selon l'invention | | | |

Lors des tests d'aptitude à la phosphatation, on constate que la totalité de la couche d'aluminium de l'essai n°2 est éliminée à l'issue du dégraissage alcalin. Quant à la couche d'oxyde de l'essai n°3, il en subsiste une partie qui n'empêche pas la bonne phosphatation de la surface en raison de sa faible épaisseur.

On constate que les tôles revêtues selon l'invention présentent une bonne aptitude à la phosphatation et une résistance à la corrosion de surface et la corrosion cosmétique améliorées par rapport à une tôle ne présentant pas un revêtement de protection temporaire selon l'invention.

En outre, les vitesses de dépôt réalisées pour les deux essais selon l'invention permettent d'extrapoler des vitesses de dépôt en production industrielle de 100 nm/face à 300 m/min.

## Revendications

1. Tôle d'acier munie d'un revêtement multicouche comprenant au moins une couche à base de zinc comprenant de 0,1 à 20% en poids de magnésium, surmontée d'une couche de protection temporaire de fine épaisseur comprise entre 5 et 100 nm et constituée de métal ou d'oxyde métallique choisi dans le groupe constitué de l'aluminium, du chrome, des oxydes d'aluminium AlOx, x étant strictement compris entre 0,01 et 1,5 et des oxydes de chrome CrOy, y étant strictement compris entre 0,01 et 1,5, ladite couche à base de zinc et comprenant 0,1 à 20% en poids de magnésium n'étant pas alliée avec ladite couche de protection temporaire.

2. Tôle selon la revendication 1, pour laquelle ledit revêtement multicouche comprend une première couche à base de zinc comprenant moins de 0,05% en poids de magnésium, surmontée d'une seconde couche à base de zinc comprenant de 0,1 à 20% en poids de magnésium, elle-même surmontée d'une couche de protection temporaire de fine épaisseur comprise entre 5 et 100 nm et constituée de métal ou d'oxyde métallique choisi dans le groupe constitué de l'aluminium, du chrome, des oxydes d'aluminium AlOx, x étant strictement compris entre 0,01 et 1,5 et des oxydes de chrome CrOy, y étant strictement compris entre 0,01 et 1,5, ladite couche à base de zinc et comprenant 0,1 à 20% en poids de magnésium n'étant alliée ni avec ladite couche de protection temporaire ni avec ladite couche à base de zinc et comprenant moins de 0,05% en poids de magnésium.

3. Tôle selon l'une ou l'autre des revendications 1 ou 2, pour laquelle la ou lesdites couches à base de zinc comprennent en outre de 0,1 à 10% en poids d'aluminium.

4. Tôle selon l'une ou l'autre des revendications 1 ou 2, pour laquelle ladite couche à base de zinc comprenant de 0,1 à 20% en poids de magnésium est constituée de Zn₂Mg.

5. Tôle selon l'une quelconque des revendications 1 à 4, pour laquelle ladite couche de protection temporaire est constituée d'aluminium.

6. Tôle selon l'une quelconque des revendications 1 à 5, pour laquelle ladite couche de protection temporaire présente une épaisseur comprise entre 5 et 50 nm.

7. Procédé de fabrication d'une tôle comprenant un revêtement multicouche selon l'une quelconque des revendications 1 à 6, selon lequel on alimente une tôle d'acier nue, puis on la revêt successivement des différentes couches constituant ledit revêtement multicouche, la couche de protection temporaire étant déposée par dépôt sous vide.

8. Procédé de fabrication selon la revendication 7, selon lequel toutes les couches du revêtement multicouche sont déposées par dépôt sous vide.

9. Procédé de fabrication d'une pièce à partir d'une tôle selon l'une quelconque des revendications 1 à 6, selon lequel on enduit ladite tôle d'une huile lubrifiante en une quantité inférieure ou égale à 1 g/m², puis on met en forme ladite tôle par emboutissage, puis on la soumet à un dégraissage alcalin.

## Patentansprüche

1. Stahlblech, welches mit einer mehrschichtigen Beschichtung versehen ist, die wenigstens eine Zink basierte Schicht mit 0,1 bis 20 Gewichts-% Magnesium aufweist, auf der eine temporäre Schutzschicht geringer Dicke, die zwischen 5 und 100 nm liegt, aufgebracht ist, die von Metall oder Metalloxid gebildet ist ausgewählt aus der Gruppe gebildet von Aluminium, Chrom, Aluminiumoxiden AlOx, wobei x strikt zwischen 0,01 und 1,5 liegt, und Chromoxiden CrOy, wobei y strikt zwischen 0,01 und 1,5 liegt, wobei die Zink basierte Schicht, die 0,1 bis 20 Gewichts-% Magnesium aufweist, nicht mit der temporären Schutzschicht vermischt ist.

2. Blech gemäß Anspruch 1, wobei die mehrschichtige Beschichtung eine erste Zink basierte Schicht mit wenigstens 0,05 Gewichts-% Magnesium aufweist, auf der eine zweite Zink basierte Schicht mit 0,1 bis 20 Gewichts-% Magnesium aufgebracht ist, auf der ihrerseits eine temporäre Schutzschicht geringer Dicke, die zwischen 5 und 100 nm liegt, aufgebracht ist, die von Metall oder Metalloxid gebildet ist ausgewählt aus der Gruppe gebildet von Aluminium, Chrom, Aluminiumoxiden AlOx, wobei x strikt zwischen 0,01 und 1,5 liegt, und Chromoxiden CrOy, wobei y strikt zwischen 0,01 und 1,5 liegt, wobei die Zink basierte Schicht, die 0,1 bis 20 Gewichts-% Magnesium aufweist, weder mit der temporären Schutzschicht, noch mit der Zink basierten Schicht, die wenigstens 0,05 Gewichts-% Magnesium aufweist, vermischt ist.

3. Blech gemäß Anspruch 1 oder 2, wobei die Zink basierte/n Schicht/en ferner 0,1 bis 10 Gewichts-% Aluminium aufweist/aufweisen.

4. Blech gemäß Anspruch 1 oder 2, wobei die Zink basierte Schicht, die 0,1 bis 20 Gewichts-% Magnesium aufweist, von Zn₂Mg gebildet ist.

5. Blech gemäß irgendeinem der Ansprüche 1 bis 4, wobei die temporäre Schutzschicht von Aluminium gebildet ist.

6. Blech gemäß irgendeinem der Ansprüche 1 bis 5, wobei die temporäre Schutzschicht eine Dicke hat, die zwischen 5 und 50 nm liegt.

7. Verfahren zur Herstellung eines Blechs, das eine mehrschichtige Beschichtung aufweist, gemäß einem der Ansprüche 1 bis 6, wobei ein blankes Stahlblech zuführt wird, dann auf dieses sukzessive die unterschiedlichen Schichten aufgebracht werden, die die mehrschichtige Beschichtung bilden, wobei die temporäre Schutzschicht unter Vakuum via Abscheidung aufgebracht wird.

8. Verfahren gemäß Anspruch 7, wobei alle Schichten der mehrschichtigen Beschichtung unter Vakuum via Abscheidung aufgebracht werden.

9. Verfahren zur Herstellung eines Bauteils ausgehend von einem Blech gemäß einem der Ansprüche 1 bis 6, wobei das Blech mit einem Schmieröl mit einer Quantität von kleiner oder gleich 1 g/m² überzogen wird, wobei dann das Blech durch Tiefziehen geformt wird, wobei es dann einer alkalischen Entfettung unterzogen wird.

## Claims

1. Steel sheet provided with a multilayer coating including at least one layer based on zinc including from 0.1 to 20% by weight of magnesium, covered with a temporary protective layer of low thickness between 5 and 100 nm and formed from metal or metallic oxide, chosen from the group formed by aluminium, chromium, AlOx aluminium oxides, x being strictly between 0.01 and 1.5 and CrOy chromium oxides, y being strictly between 0.01 and 1.5, said layer based on zinc and including 0.1 to 20% by weight of magnesium not being alloyed with said temporary protective layer.

2. Sheet according to claim 1, for which said multilayer coating includes a first layer based on zinc including less than 0.05% by weight of magnesium, covered by a second layer based on zinc including from 0.1 to 20% by weight of magnesium, itself covered by a temporary protective layer of low thickness between 5 and 100 nm and formed from metal or metallic oxide chosen from the group formed by aluminium, chromium, AlOx aluminium oxides, x being strictly between 0.01 and 1.5 and CrOy chromium oxides, y being strictly between 0.01 and 1.5, said layer based on zinc and including 0.1 to 20% by weight of magnesium not being alloyed either with said temporary protective layer or with said layer based on zinc and including less than 0.05% by weight of magnesium.

3. Sheet according to one or other of claims 1 or 2, for which the layer or layers based on zinc include furthermore from 0.1 to 10% by weight of aluminium.

4. Sheet according to one or other of claims 1 or 2, for which said layer based on zinc including from 0.1 to 20% by weight of magnesium is formed from Zn₂Mg.

5. Sheet according to any of claims 1 to 4, for which said temporary protective layer is formed from aluminium.

6. Sheet according to any of claims 1 to 5, for which said temporary protective layer has a thickness between 5 and 50 nm.

7. Method for manufacturing a sheet including a multilayer coating according to any of claims 1 to 6, according to which a bare steel sheet is supplied, then it is coated successively with various layers forming said multilayer coating, the temporary protective layer being deposited by vacuum deposition.

8. Method for manufacturing according to claim 7, according to which all the layers of the multilayer coating are deposited by vacuum deposition.

9. Method for manufacturing a part from a sheet according to any of claims 1 to 6, according to which said sheet is coated with a lubricating oil in a quantity less than or equal to 1 g/m², then said sheet is formed by drawing, then it is subjected to alkaline degreasing.
